# EUROPEAN PATENT APPLICATION

(11) **EP 4 672 872 A1**
(43) Date of publication of application: **31.12.2025**
(21) Application number: 24758700.9
(22) Date of filing: 25.01.2024
(51) Int. Cl.: H05K 3/38

(54) **PREPARATION METHOD FOR ACTIVE METAL WELDED CERAMIC SUBSTRATE**

(30) Priority: 23.02.2023 CN 202310152948
(71) Applicant: Lee, Shao-Lun, Taipei City Taiwan 106 (TW)
(72) Inventor: Lee, Shao-Lun, Taipei City Taiwan 106 (TW)
(74) Representative: Wittmann, Günther
(86) International application number: PCT/CN2024/073979
(87) International publication number: WO 2024/174802

(57) **Abstract**

The present invention relates to a preparation method for active metal-brazed ceramic substrates. The preparation method comprises the steps of forming respective surface optimization layers on the upper surface and the lower surface of a ceramic substrate by atomic layer deposition; forming respective first solder layers on the surface optimization layers by atomic layer deposition; forming respective third solder layers on the surfaces of two copper plates facing the upper surface and the lower surface of the ceramic substrate; and finally, stacking the ceramic substrate and the two copper plates with the ceramic substrate sandwiched therebetween to form a layered structure and then performing high-temperature hot-pressing brazing on the layered structure to form an active metal-brazed ceramic substrate.

## Description

### TECHNICAL FIELD

The present invention relates to a preparation method for active metal-brazed ceramic substrates and in particular to a method for reducing the post-brazing void rate in an active metal brazing process.

### BACKGROUND OF THE INVENTION

Active Metal Brazing (AMB) is a method of bonding ceramics to metals by using a small amount of active elements contained in the solder to react with the ceramics so as to form a reaction layer that can be wetted by the liquid solder.

Typically, the ceramic surface is printed with active metal solder, clamped to oxygen-free copper, and then brazed at high temperature in a vacuum brazing furnace. After the bonding is completed, a wet etching process similar to that of a PCB board is used to make a circuit on the surface. Finally, the surface is plated to produce a product with reliable performance.

The bonding is achieved for the AMB substrate by chemical reaction between ceramic and active metal solder paste at high temperature so that its bonding strength is higher and its reliability is better. However, due to the high cost of this method, availability of suitable solder, and the significant impact of solder on brazing reliability, there are currently only a few Japanese companies that have mastered high-reliability active metal brazing technologies.

At present, the void ratio of the ceramic interface is an important factor in substrate quality. Therefore, the control of the void ratio of the ceramic interface is crucial. If the void ratio of the interface is good, the service reliability of the substrate under high temperature and high current can be guaranteed.

Taking Ag-Cu-Ti active solder as an example, the causes of void formation are as follows:
(1)raw material surface quality: scratches, pits, oxidation, organic contamination, and other problems on the surfaces of ceramics, oxygen-free copper, and solder pads before brazing will have a negative impact on the wetting and spreading of the solder, bringing potential void risks to the brazing interface; regarding this part, the surface defects of Si₃N₄ ceramic materials generally include the following surface contamination and defects: particle contamination, surface roughness, surface cracks, surface contamination, point defects, dislocations, microcracks, and impurities, wherein point defects, dislocations, microcracks, impurities, and surface contamination will have the greatest impact; when titanium is used to perform wetting on the surface, it will easily penetrate into the ceramic substrate due to surface defects if it has not been handled properly, leading to the risk of voids and causing negative effects such as weakening the strength of the substrate-copper film bonding interface, further leading to the risk of voids;
(2)active element deactivation: the active element (Ti) in Ag-Cu-Ti is very sensitive to oxygen; therefore, during the high-temperature brazing process, a vacuum degree better than 10⁻³Pa is often required; if the vacuum degree cannot meet the brazing requirement, Ti will be oxidized and deactivated, and the solder will not be able to wet the Si₃N₄ ceramic surface, resulting in large-area faulty solder joints and leaky solder joints;
(3)brazing process parameters: usually, the Ag-Cu-Ti active brazing filler metal can only wet the Si₃N₄ surface at a temperature of over 800°C; if the brazing temperature is too low or the holding time is too short, the reaction between Ti and the ceramic surface will not be sufficient, resulting in the brazing filler metal being unable to completely wet the ceramic surface;
(4)solder paste printing quality: during the large-area solder paste printing process, it is more likely to have problems such as solder paste skipping and uneven printing; once the solder melts and does not spread to cover these solder skipping areas, it will directly lead to the formation of voids;
(5)solder paste outgassing: during the brazing process, the gas volatilized in the solder paste will be wrapped in the flux to form bubbles; additionally, the reaction between the organic acid and the metal oxide in the flux will also produce bubbles; as the reaction proceeds, the bubbles gradually grow larger; discharged bubbles will leave dense pores on the surface of the solder paste, and the bubbles that are not discharged will also be retained at the brazing interface as the solder melts and solidifies, forming voids and causing the risk of fracture of the substrate-copper film bonding interface during long-term operation.

The general way to reduce the void rate is to remove oil and oxidation from the ceramics and copper sheets and provide a high vacuum brazing environment during the preparation of silicon nitride copper-clad substrates through the AMB process. This is a well-known method for reducing interface void rate, but its effectiveness is still very limited, and there is an urgent need for an effectively improved method.

Therefore, in the present invention, respective surface optimization layers (silicon nitride, aluminum oxide, or aluminum nitride) are first formed on the upper and lower surfaces of a ceramic substrate by ALD to cover surface defects and flatten the upper and lower surfaces of the ceramic substrate so as to reduce the probability of void formation. In addition, ALD is further used to form respective first solder layers (titanium or titanium nitride) on the surface optimization layers and to form respective third solder layers (silver) on the surfaces of two copper plates. In this way, when the ceramic substrate and the two copper plates are staked on top of each other with the ceramic substrate sandwiched therebetween and then subjected to the high-temperature hot-pressing brazing process to form an active metal-brazed ceramic substrate, the probability of void formation will be significantly reduced. Therefore, the present invention should be an optimal solution.

### SUMMARY OF THE INVENTION

The present invention provides a preparation method for active metal-brazed ceramic substrates, which comprises the steps of:
(1)forming respective surface optimization layers on the upper surface and the lower surface of a ceramic substrate by atomic layer deposition, wherein the surface optimization layers are composed of silicon nitride, aluminum oxide, or aluminum nitride;
(2) forming respective first solder layers on the surface optimization layers by atomic layer deposition, wherein the first solder layers are composed of titanium;
(3) forming respective third solder layers on the surfaces of two copper plates facing the upper surface and the lower surface of the ceramic substrate, wherein the third solder layers are at least composed of copper and silver; and
(4) stacking the ceramic substrate and the two copper plates with the ceramic substrate sandwiched therebetween to form a layered structure and then performing high-temperature hot-pressing brazing on the layered structure to form an active metal-brazed ceramic substrate.

More particularly, the surface optimization layers are used to cover surface defects on the upper and lower surfaces of the ceramic substrate.

More particularly, the preparation method further comprises a step of performing atomic layer etching on the upper and lower surfaces of the ceramic substrate before forming the surface optimization layers on the upper surface and the lower surface of the ceramic substrate by atomic layer deposition, wherein the atomic layer etching is used to remove the surface defects on the upper and lower surfaces of the ceramic substrate.

More particularly, the surface optimization layers have a thickness of 1nm-1µm.

More particularly, the preparation method further comprises a step of forming respective second solder layers on the first solder layers, wherein the second solder layers are composed of titanium nitride.

More particularly, the second solder layers have a thickness of 0.1-100nm.

More particularly, the first solder layers have a thickness of 0.1-100nm.

More particularly, the third solder layers have a thickness of 0.1-100µm.

More particularly, the third solder layers further contains titanium.

More particularly, the high-temperature hot-pressing brazing is performed at a temperature of 750-950°C.

### BRIEF DESCRIPTION OF DRAWINGS

Fig. 1 is a schematic flow chart of a preparation method for active metal-brazed ceramic substrates of the present invention.
Fig. 2A is a schematic diagram of the separated structure of an active metal-brazed ceramic substrate in the preparation method for active metal-brazed ceramic substrates of the present invention.
Fig. 2B is a schematic diagram of the structure of the active metal-brazed ceramic substrate after hot pressing in the preparation method for active metal-brazed ceramic substrates of the present invention.
Fig. 3 is another schematic diagram of the structure of a ceramic substrate and first solder layers in the preparation method for active metal-brazed ceramic substrates of the present invention.

### DETAILED DESCRIPTION OF THE INVENTION

Other technical contents, features, and effects of the present invention will be clearly presented in the following detailed description of the preferred embodiments with reference to the drawings.

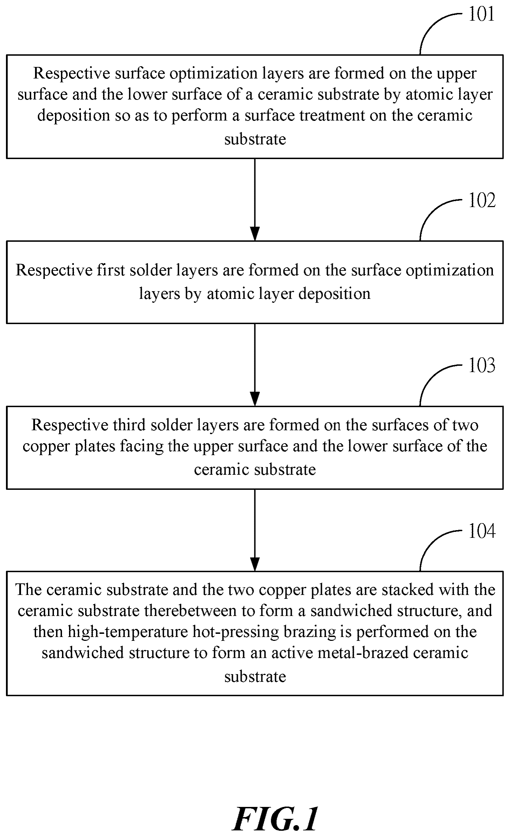

Please referring to Fig. 1, the preparation method for active metal-brazed ceramic substrates comprises the steps of :
(1)forming respective surface optimization layers on the upper surface and the lower surface of a ceramic substrate by atomic layer deposition, wherein the surface optimization layers are composed of silicon nitride, aluminum oxide, or aluminum nitride (101);
(2)forming respective first solder layers on the surface optimization layers by atomic layer deposition, wherein the first solder layers are composed of titanium (102);
(3)forming respective third solder layers on the surfaces of two copper plates facing the upper surface and the lower surface of the ceramic substrate, wherein the third solder layers are at least composed of copper and silver (103); and
(4)stacking the ceramic substrate and the two copper plates with the ceramic substrate sandwiched therebetween to form a layered structure and then performing high-temperature hot-pressing brazing on the layered structure to form an active metal-brazed ceramic substrate (104).

The high-temperature hot-pressing brazing is performed at a temperature of 750-950°C.

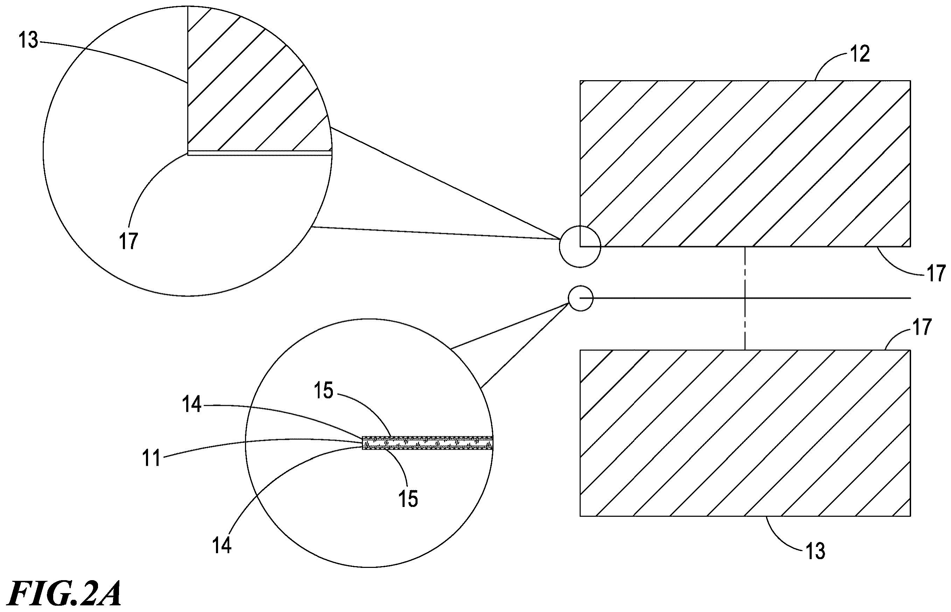

As shown in Fig. 2A, the active metal-brazed ceramic substrate includes a ceramic substrate 11 and two copper plates 12 and 13, wherein the upper and lower surfaces of the ceramic substrate 11 are attached with respective surface optimization layers 14, and the materials of the surface optimization layers 14 are Si₃N₄, AlN, or Al₂O₃.

The surface optimization layers 14 have a thickness of 1nm-1µm.

The surface optimization layers 14 are used to cover surface defects on the upper and lower surfaces of the ceramic substrate 11.

The surface optimization layers 14 are attached with respective first solder layers 15 (titanium).

The surfaces of the two copper plates 12 and 13 facing the surfaces of the ceramic substrate 11 are attached with respective third solder layer 17 (copper, silver, titanium), wherein the third solder layers 17 are composed of silver, copper, and titanium (silver accounts for 66-72% in composition, copper accounts for 28-32% in composition, and titanium accounts for 0-6% in composition).

The third solder layers 17 are formed on the surfaces of the two copper plates 12, 13 by sputtering or atomic layer deposition.

The first solder layers 15 have a thickness of 0.1-100nm.

The third solder layers 17 have a thickness of 0.1-100µm.

The copper pates 12, 13 have a thickness of 100-1000µm.

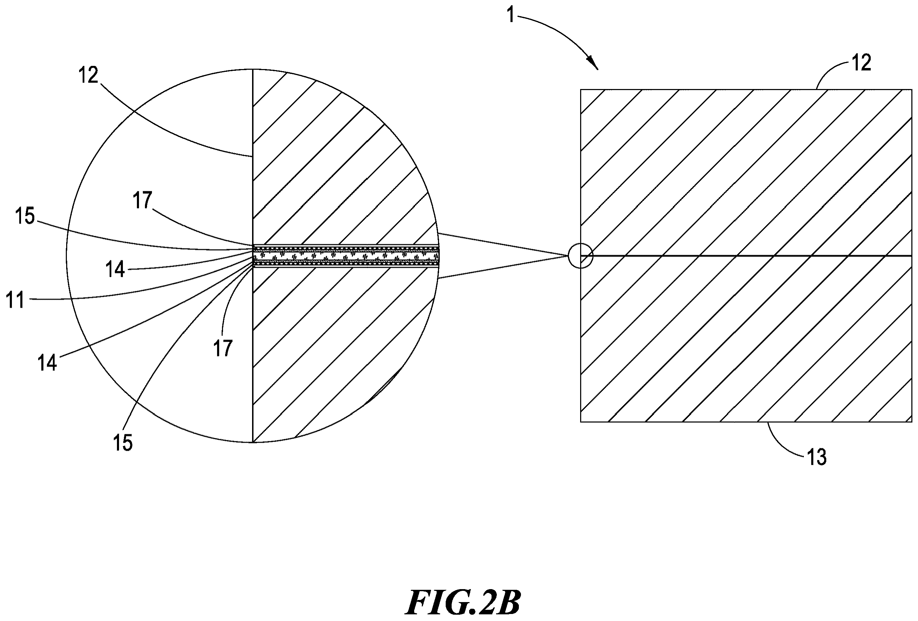

As shown in Fig. 2B, the ceramic substrate 11 and the two copper plates 12, 13 are staked with the ceramic substrate 11 sandwiched therebetween to form a layered structure, and then high-temperature hot-pressing brazing is performed on the layered structure to form an active metal-brazed ceramic substrate 1.

The atomic layer deposition (ALD) process is a prior art, in which a chemical gas containing the components to be deposited reacts with the ceramic substrate; the chemical gas is removed with a large amount of inert gas (such as nitrogen or argon); and then the above step is repeated. This allows all reactions to occur only on the surface of the ceramic substrate, and each cycle only forms a thin film with a thickness of one atom. Therefore, this allows the thickness of each coating to be accurate to the atomic level (approximately 0.1 nm) with excellent uniformity. Because the growth process is confined to the surface of the ceramic substrate, good coverage and uniformity can be achieved on the structured surface.

The atomic layer deposition (ALD) is used to cover the defects on the upper and lower surfaces of the ceramic substrate, such as point defects, dislocations, microcracks, impurities, and surface contamination, to make the surface flat.

In the present invention, although the atom layer deposition (ALD) is performed to cover the surface defects, better results can be achieved if the atom layer etching (ALE) is performed to remove the surface micro-defects before the atom layer deposition (ALD) performed.

Therefore, the upper and lower surfaces of the ceramic substrate 11 can be first subjected to the atomic layer etching and then subjected to the atomic layer deposition to form the surface optimization layers. The atomic layer etching is used to remove the surface defects on the upper and lower surfaces of the ceramic substrate 11.

The atomic layer etching (ALE) process is a prior art, in which an etching gas and an inert gas are supplied to a reaction space through a mass flow controller; and then plasma is used for etching, wherein the inert gas or nitrogen supplied to the reaction space as the basic reaction gas is used for generating plasma. In addition, it is also possible to add an oxidizing gas or a reducing gas such as hydrogen to control the etching rate. The process temperature is mostly controlled between 0 and 250 degrees.

The atomic layer etching (ALE) is used to remove the defects on the upper and lower surfaces of the ceramic substrate, such as point defects, dislocations, microcracks, and surface contamination.

The surface optimization layers 14, the first solder layers 15, and second solder layers 16 on the upper and lower surfaces of the ceramic substrate 11 are in contact with the third solder layers 17 of the copper plates 12, 13, and then they are vacuum-packaged using a heat-conductive material to obtain the layered structure. The vacuum degree of the vacuum packaging is less than 10⁻¹ Pa, and the heat-conductive material is a flexible metal foil bag.

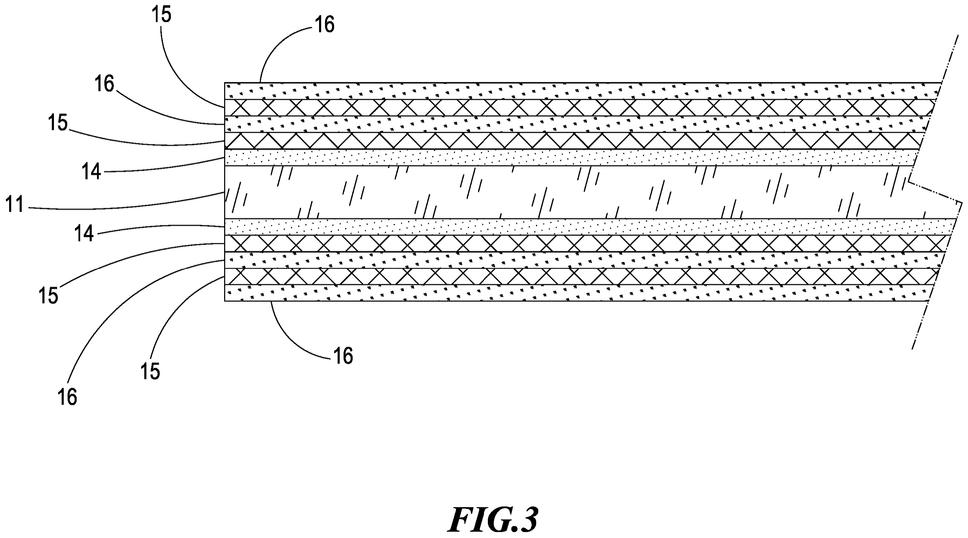

As shown in Fig. 3, the first solders 15 can be further formed with respective second solder layers 16 thereon. The second solder layers 16 are composed of titanium nitride. The second solder layers 16 have an anti-oxidation function to prevent or reduce the possibility of oxidation of the first solder layers 15. The present invention can be implemented by forming only the first solder layers 15 or by forming the first solder layers 15 and the second solder layers 16, wherein the outermost layer of the multiple layers is one first solder layer 15 or one second solder layer 16.

The second solder layers have a thickness of 0.1-100nm.

The second solder layers 16 mainly prevents titanium in the first solder layers 15 from being oxidized during a subsequent high-temperature treatment and controls the formation of intermetallic effectively.

The ceramic substrate 11 is further degreased so that the first solder layers 15 and the second solder layers 16 are heated and degreased in an inert gas or reducing gas atmosphere and attached to the upper and lower surfaces of the ceramic substrate 11. The inert gas includes nitrogen or argon, and the reducing gas includes hydrogen, nitrogen-hydrogen mixed gas or acidic gas.

The copper plates 12, 13 are further degreased so that the third solder layers 17 are heated and degreased in an inert gas or reducing gas atmosphere and adhered to the surfaces of the copper plates 12, 13.

Since in the present invention, the upper and lower surfaces of the ceramic substrate are treated by atomic layer etching (ALE) and atomic layer deposition (ALD), the probability of void formation can be reduced.

Since the first solder layers are formed using atomic layer deposition (ALD), their thickness can be precisely controlled to ensure the surfaces uniform and flat. In addition to achieving good connectivity with the ceramic substrate, the formation of an intermetallic layer between the ceramic substrate and the metal solder can be controlled effectively because the first solder layer is uniformly thin.

The preparation method for active metal-brazed ceramic substrates provided by the present invention has the following advantages when compared with other conventional technologies:
(1)in the present invention, a surface treatment is performed on the upper and lower surfaces of the ceramic substrate (to remove surface micro-defects) through atomic layer etching (ALE); this will reduce the probability of void formation and improve the yield of preparing the active metal-brazed ceramic substrates;
(2)In the present invention, the surface optimization layers (silicon nitride, aluminum oxide, or aluminum nitride) are formed on the upper and lower surfaces of the ceramic substrate through atomic layer deposition (ALD) so that the surfaces are better treated (to cover surface defects) while the probability of void formation can be reduced, and the yield of preparing the active metal-brazed ceramic substrates can be improved;
(3)in the present invention, through atomic layer etching (ALE) and atomic layer deposition (ALD), the wetting ability of the first solder layers (titanium) on the ceramic substrate can be improved to enhance the bonding strength between copper and the substrate.

The present invention has been disclosed through the above-mentioned embodiments, but these embodiments are not used to limit the present invention. Any person having ordinary skill in the art can make some changes and modifications without departing from the spirit and scope of the present invention after understanding the above-mentioned technical features and embodiments of the present invention.

## Claims

1. A preparation method for active metal-brazed ceramic substrates 1, comprising the steps of:
forming respective surface optimization layers 14 on the upper surface and the lower surface of a ceramic substrate 11 by atomic layer deposition, wherein the surface optimization layers 14 are composed of silicon nitride, aluminum oxide, or aluminum nitride;
forming respective first solder layers 15 on the surface optimization layers 14 by atomic layer deposition, wherein the first solder layers 15 are composed of titanium;
forming respective third solder layers 17 on the surfaces of two copper plates 12,13 facing the upper surface and the lower surface of the ceramic substrate 11, wherein the third solder layers 17 are at least composed of copper and silver; and
stacking the ceramic substrate 11 and the two copper plates 12,13 with the ceramic substrate 11 sandwiched therebetween to form a layered structure and then performing high-temperature hot-pressing brazing on the layered structure to form an active metal-brazed ceramic substrate 1.

2. The preparation method of claim 1, wherein the surface optimization layers 14 are used to cover surface defects on the upper and lower surfaces of the ceramic substrate 11.

3. The preparation method of claim 1, further comprising a step of performing atomic layer etching on the upper and lower surfaces of the ceramic substrate 11 before forming the surface optimization layers 14 on the upper surface and the lower surface of the ceramic substrate 11 by atomic layer deposition, wherein the atomic layer etching is used to remove the surface defects on the upper and lower surfaces of the ceramic substrate 11.

4. The preparation method of claim 1, wherein the surface optimization layers 14 have a thickness of 1nm-1µm.

5. The preparation method of claim 1, further comprising a step of forming respective second solder layers 16 on the first solder layers 15, wherein the second solder layers 16 are composed of titanium nitride.

6. The preparation method of claim 5, wherein the second solder layers 16 have a thickness of 0.1-100nm.

7. The preparation method of claim 1, wherein the first solder layers 15 have a thickness of 0.1-100nm.

8. The preparation method of claim 1, wherein the third solder layers 17 have a thickness of 0.1-100µm.

9. The preparation method of claim 1, wherein the third solder layers 17 further contains titanium.

10. The preparation method of claim 1, wherein the high-temperature hot-pressing brazing is performed at a temperature of 750-950°C.
